# EUROPÄISCHE PATENTSCHRIFT

(11) **EP 3 145 762 B1**
(45) Veröffentlichungstag und Bekanntmachung des Hinweises auf die Patenterteilung: **11.07.2018**
(21) Anmeldenummer: 15723961.7
(22) Anmeldetag: 21.05.2015
(51) Int. Cl.: B60R 25/20, E05F 15/73, H03K 17/955

(54) **FAHRZEUGTEIL FUER DEN AUSSENBEREICH EINES KRAFTFAHRZEUGS UND KRAFTFAHRZEUG**
VEHICLE PART FOR THE EXTERIOR AREA OF A MOTOR VEHICLE, AND MOTOR VEHICLE
PIECE DESTINEE A ETRE MONTEE SUR UNE PARTIE EXTERNE D'UN VEHICULE A MOTEUR ET VEHICULE A MOTEUR

(30) Priorität: 23.05.2014 DE 102014007651
(43) Veröffentlichungstag der Anmeldung: 29.03.2017
(73) Patentinhaber: Brose Fahrzeugteile GmbH & Co. Kommanditgesellschaft, Bamberg, 96052 Bamberg (DE)
(72) Erfinder: HERTHAN, Bernd, 96247 Michelau (DE); SCHNEIDER, Karl, 74354 Besigheim (DE)
(74) Vertreter: FDST Patentanwälte
(86) Internationale Anmeldenummer: PCT/EP2015/061234
(87) Internationale Veröffentlichungsnummer: WO 2015/177272

(56) Entgegenhaltungen:
- EP-A1- 1 235 190
- WO-A1-2009/092577
- DE-A1-102006 051 323
- DE-A1-102009 034 549
- DE-A1-102010 002 559
- DE-A1-102011 111 208
- FR-A1- 2 933 825

## Beschreibung

Die Erfindung betrifft ein Fahrzeugteil für den Außenbereich eines Kraftfahrzeugs. Des Weiteren betrifft die Erfindung ein Kraftfahrzeug.

Bei modernen (Kraft-)Fahrzeugen, insbesondere Personenkraftwagen, kommen häufig berührungslos messende (z. B. kapazitive) Abstandssensoren zum Einsatz. Oft werden diese im Rahmen von Stellvorrichtungen eingesetzt, die einen Türöffnungswunsch eines Fahrzeugnutzers (berührungslos) erkennen und daraufhin ein zugeordnetes Verstellteil automatisch bewegen. Meist handelt es sich bei dem Verstellteil um eine Fahrzeugtür, insbesondere um eine Heckklappe des Fahrzeugs, die zum reversiblen Verschließen des Kofferraums eingerichtet und vorgesehen ist (auch als Kofferraumtür oder Kofferraumdeckel bezeichnet). Die Stellvorrichtung ist dabei insbesondere dazu eingerichtet, den Türöffnungswunsch anhand einer Annäherung (nach Art eines kapazitiven Schalters) oder einer Bewegung des Fahrzeugnutzers zu erkennen. Das mittels des Abstandssensors erfasste Messsignal wird in letzterem Fall in einer Steuer- und Auswerteeinheit mit einem hinterlegten Referenzsignal verglichen. Bei hinreichender Übereinstimmung des Messsignals mit dem Referenzsignal schließt die Steuer- und Auswerteeinheit auf den Türöffnungswunsch und steuert die Fahrzeugtür zum Öffnen an.

Der Vorteil einer solchen berührungslosen Erkennung des Türöffnungswunsches ist, dass der Fahrzeugnutzer beide Hände zum Tragen von Ladungsgegenständen (z. B. einer Getränkekiste) verfügbar hat. Zur Erkennung des Türöffnungswunsches ist dabei meist eine Fußbewegung vorgesehen, insbesondere eine trittartige Fußbewegung in Richtung des heckseitigen Stoßfängers des Fahrzeugs (auch als "Fußkick" bezeichnet). Um diesen Fußkick möglichst störungsfrei erkennen zu können, ist der Abstandssensor meist im unteren Bereich des Fahrzeughecks angeordnet.

Insbesondere bei der Verwendung von kapazitiven Abstandssensoren können allerdings metallische Gegenstände in der näheren Umgebung der kapazitiven Sensorelektrode die kapazitive Erfassung einer Bewegung beeinflussen. Herkömmlicherweise werden die Sensorelektroden der kapazitiven Abstandssensoren mit einem hinreichenden Abstand zu solchen metallischen Gegenständen angeordnet (bspw. wellenartig um diese herum geführt), so dass die Beeinflussung des Messsignals vernachlässigbar ist. Allerdings ist häufig der verfügbare Bauraum im Bereich der Fahrzeugteile, an denen die Sensorelektroden anzubringen sind, derart klein, dass eine frei wählbare Anordnung der Sensorelektroden nicht oder nur mit vergleichsweise hohem konstruktiven Aufwand möglich ist.

Fahrzeugteile mit daran angeordneten Sensoren zur insbesondere berührungslosen Erkennung eines Türöffnungswunsches sind beispielsweise aus DE 10 2011 111 208 A1, DE 10 2009 034 549 A1 und EP 1 235 190 A1 bekannt.

Der Erfindung liegt die Aufgabe zugrunde, die Verwendung von kapazitiven Sensorelektroden an einem Kraftfahrzeug zu vereinfachen.

Diese Aufgabe wird hinsichtlich eines Fahrzeugteils für den Außenbereich eines (Kraft-)Fahrzeugs erfindungsgemäß gelöst durch die Merkmale des Anspruchs 1. Hinsichtlich eines Kraftfahrzeugs wird die Aufgabe erfindungsgemäß gelöst durch die Merkmale des Anspruchs 6. Vorteilhafte und teils für sich erfinderische Ausführungsformen und Weiterentwicklungen der Erfindung sind in den Unteransprüchen und der nachfolgenden Beschreibung dargelegt.

Das erfindungsgemäße Fahrzeugteil umfasst wenigstens eine Sensorelektrode eines kapazitiven Näherungssensors. Diese (wenigstens eine) Sensorelektrode ist dabei auf einer Sichtseite des Fahrzeugteils angeordnet. Das Fahrzeugteil ist hierbei zur Montage im Außenbereich, also als Teil der Außenhaut des Fahrzeugs eingerichtet und vorgesehen.

Unter Sichtseite wird hier und im Folgenden die Seite des Fahrzeugteils verstanden, die im bestimmungsgemäßen Einbauzustand in dem Fahrzeug einen Teil der Außenseite (also des Außenbereichs) des Fahrzeugs bildet, d. h. nach außen gerichtet und somit für eine in der Umgebung des Fahrzeugs befindliche Person sichtbar ist. Entsprechend wird im Folgenden mit "Sichtfläche" die von außerhalb des Fahrzeugs sichtbare Oberfläche (oder auch Außenhaut) des Fahrzeugteils (oder des Fahrzeugs selbst) bezeichnet.

Die Anordnung der Sensorelektrode auf der Sichtseite des Fahrzeugteils ist dabei insbesondere vorteilhaft, da auf der Innenseite (also der der Fahrzeugkarosserie zugewandten Seite; diese wird alternativ auch als Rückseite bezeichnet) des Fahrzeugteils häufig nur wenig Bauraum zur frei wählbaren Positionierung der Sensorelektrode vorhanden ist. Außerdem wird ein von der sichtseitig angeordneten Sensorelektrode zur Außenseite hin abgestrahltes elektrisches (Mess-)Feld nicht oder nur geringfügig durch gegebenenfalls in dem Fahrzeugteil enthaltenes Metall beeinflusst, so dass eine hohe Messpräzision ermöglicht wird.

Vorzugsweise werden die Sensorelektrode und der übergeordnete Näherungssensor zur berührungslosen Detektion eines Befehls eines Fahrzeugnutzers eingesetzt. Bei einem solchen Befehl handelt es sich insbesondere um einen Verstellbefehl für ein automatisch verstellbares Fahrzeugteil, wie beispielsweise eine Fahrzeugtür - vorzugsweise die (auch als Heckklappe oder Kofferraumtür bezeichnete) zum Verschließen des Kofferraums eingerichtete Fahrzeugtür. In diesem Fall ist der Näherungssensor insbesondere als Teil einer bewegungssensitiven Stellvorrichtung für diese Fahrzeugtür ausgeführt. Die Stellvorrichtung ist dabei zweckmäßigerweise dazu eingerichtet, anhand des von dem Näherungssensor ausgegebenen Messsignals - das regelmäßig eine Annäherung oder ein vorbestimmtes Bedienereignis wiederspiegelt - den Verstellbefehl des Fahrzeugnutzers zu erkennen. In diesem Fall ist die Sensorelektrode vorzugsweise optisch von dem Fahrzeugteil abgesetzt, so dass der Fahrzeugnutzer vorteilhafterweise ohne zusätzliche (optischen) Hinweise erkennen kann, an welcher Stelle sich die Sensorelektrode befindet.

Damit mittels des Näherungssensors (und der Stellvorrichtung) insbesondere eine Bewegung des Fahrzeugnutzers relativ zu dem Fahrzeugteil präzise detektiert werden kann, umfasst dieses zweckmäßigerweise zwei Sensorelektroden, die wie vorstehend beschrieben auf der Sichtseite des Fahrzeugteils angeordnet sind. Die beiden Sensorelektroden sind dabei insbesondere jeweils langgestreckt (d. h. mit einer gegenüber ihrer Breite vielfach größeren Länge) ausgeführt und parallel zueinander ausgerichtet. Vorzugsweise sind die beiden Sensorelektroden im bestimmungsgemäßen Einbauzustand dabei auch mit ihrer Längserstreckung quer zur Fahrzeughochrichtung ausgerichtet, verlaufen also in Breitenrichtung des Fahrzeugs.

Die Sensorelektrode oder insbesondere beide Sensorelektroden sind in jeweils einem Sensorhalter aufgenommen. Der jeweilige Sensorhalter liegt dabei insbesondere sichtbar (also optisch abgesetzt) auf der Sichtfläche des Fahrzeugteils auf. Im Rahmen der Erfindung ist es dabei denkbar, dass der Sensorhalter auf dem Fahrzeugteil bspw. mittels einer Clipsverbindung aufgesteckt, aufgeklebt oder mittels Schrauben befestigt ist. Im Rahmen der Erfindung ist es dabei auch denkbar, dass beide Sensorelektroden in einem gemeinsamen Sensorhalter aufgenommen sind. Die Sensorelektroden sind in einfacher Ausführung in dem (jeweiligen) Sensorhalter eingelegt und werden insbesondere durch die Befestigung des Sensorhalters an dem Fahrzeugteil in Position gehalten. Alternativ sind die Sensorelektroden (vorzugsweise spritzgießtechnisch) in den Sensorhalter integriert oder als Metallschicht auf die Rückseite des Sensorhalters aufgedampft. Dadurch, dass der Sensorhalter auf dem Fahrzeugteil aufliegt, kann das Fahrzeugteil besonders einfach gefertigt werden - insbesondere sind lediglich Durchbrüche für ein Leitungskabel für die jeweilige Sensorelektrode und vorzugsweise für eine zumindest teilweise formschlüssige Verbindung des Sensorhalters vorzusehen.

Um eine in Richtung zur Außenseite des Fahrzeugs uneingeschränkte Ausbreitung des elektrischen Felds um die Sensorelektroden zu ermöglichen, ist der oder jeder Sensorhalter zweckmäßigerweise aus vorzugsweise weichem Kunststoff, insbesondere Elastomer gefertigt. Die Sensorhalter sind dabei vorzugsweise derart gestaltet, dass sie auf dem Fahrzeugteil als "Gummiwulst" sichtbar (und somit auch ertastbar) sind.

Bei dem Fahrzeugteil handelt es sich um einen aus Metall gefertigten (folglich elektrisch leitfähigen) Unterfahrschutz, insbesondere einen Heck-Unterfahrschutz. Ein solcher Unterfahrschutz findet herkömmlicherweise bei Geländefahrzeugen (auch Geländewagen) oder sogenannten Sports Utility Vehicles (kurz SUV) Anwendung, um bei einer Geländefahrt Beschädigungen des Unterbodens und/oder der Front- oder Heckstoßfänger beim Überfahren von Hindernissen zu vermeiden. Durch die Anbringung der Sensorelektroden bzw. der diese tragenden Sensorhalter auf der Sichtseite des Unterfahrschutzes kann mittels der Sensorelektroden auch eine Bewegung unterhalb des Fahrzeugs bzw. des Unterfahrschutzes erfasst werden, da das Metall des Unterfahrschutzes außerhalb des elektrischen (Mess-)Felds der Sensorelektroden angeordnet ist (das Feld mithin nicht abgeschirmt wird). Mittels des jeweiligen Sensorhalters ist vorzugsweise ein Abstand von beispielsweise 2 bis 10 mm für die jeweilige Sensorelektrode zu dem metallenen Unterfahrschutz vorgegeben. Außerdem wird durch den (bzw. gegebenenfalls die zwei) vorzugsweise als Gummiwulst ausgestalteten Sensorhalter ein dem "sportlichen" Gesamterscheinungsbild des Geländewagens angepasster optischer Eindruck für den Fahrzeugnutzer erreicht.

Bevorzugt bildet das Fahrzeugteil mit der bzw. den Sensorelektroden (sowie mit den zugeordneten Sensorhaltern) eine Vormontageeinheit, die während der Montage des Fahrzeugs als zusammenhängendes Bauteil an diesem montiert wird, wobei vorzugsweise zusätzlich zur Befestigung des Fahrzeugteils an dem Fahrzeug nur noch die Sensorelektroden mit einer Steuer- und/oder Auswerteeinheit kontaktiert werden müssen.

Das erfindungsgemäße (Kraft-)Fahrzeug umfasst das Fahrzeugteil der vorstehend beschriebenen Art, das im Außenbereich des Fahrzeugs angeordnet ist. Bei dem Fahrzeug handelt es sich vorzugsweise um einen Geländewagen oder ein SUV.

Nachfolgend werden Ausführungsbeispiele der Erfindung anhand einer Zeichnung näher erläutert. Darin zeigen:
- Fig. 1: in schematischer Darstellung das Heck eines Kraftfahrzeugs mit einem Fahrzeugteil, das zwei Sensorelektroden trägt, und
- Fig. 2: in einem schematischen Schnitt II-II gemäß Fig. 1 das Fahrzeugteil mit den Sensorelektroden.

Einander entsprechende Teile sind in allen Figuren stets mit gleichen Bezugszeichen versehen.

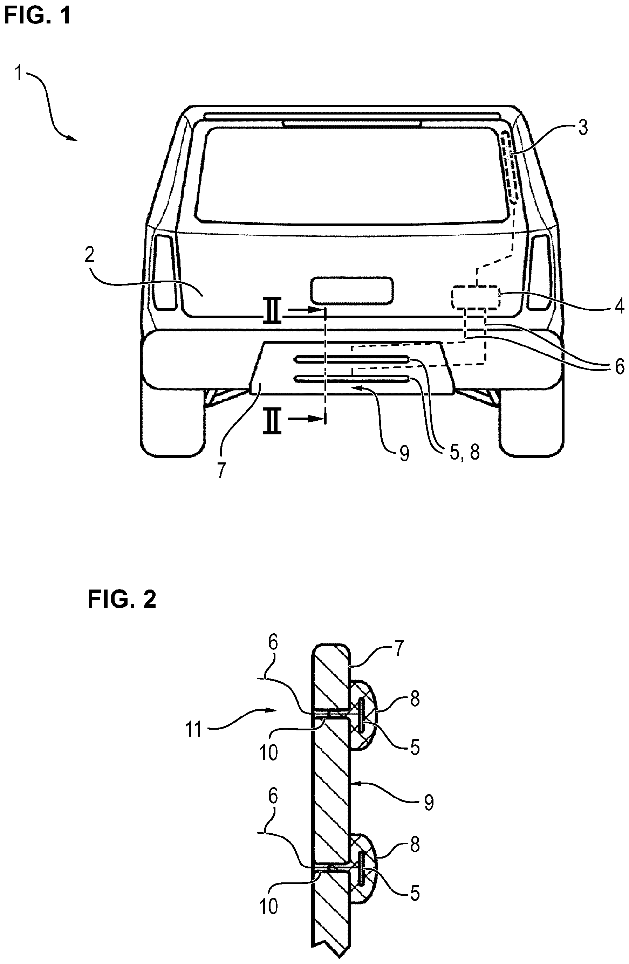

In Fig. 1 ist ein (Kraft-)Fahrzeug 1 in Ansicht auf dessen Heck dargestellt. Bei dem Fahrzeug 1 handelt es ich um ein SUV. Ein im Inneren des Fahrzeugs 1 angeordneter Kofferraum ist reversibel durch eine Fahrzeugtür (hier die Heckklappe 2) verschließbar. Die Heckklappe 2 ist automatisch zwischen einer (nicht näher dargestellten) Offenstellung und einer in Fig. 1 gezeigten Schließstellung verstellbar. Dazu umfasst das Fahrzeug 1 eine Stellvorrichtung mit einem (Klappen-)Stellmotor 3, der als Spindelmotor ausgeführt ist und im Bereich der Scharniere der Heckklappe 2 angelenkt ist. Die Stellvorrichtung weist eine Steuereinheit 4 auf, mittels derer der Stellmotor 3 im Betrieb angesteuert wird.

Die Steuereinheit 4 ist dazu eingerichtet und vorgesehen, berührungslos einen Heckklappenstellbefehl eines Fahrzeugnutzers zu erkennen und daraufhin die Heckklappe 2 zu öffnen oder zu schließen. Dazu ist in der Steuereinheit 4 ein kapazitiver Näherungssensor integriert, mittels dessen eine Annäherung des Fahrzeugnutzers an das Fahrzeug 1 und aus dem zeitlichen Verlauf der Annäherung eine Bewegung detektiert wird. Die detektierte Bewegung, konkret das mit dieser korrespondierende Messsignal, wird von der Steuereinheit 4 mit einem hinterlegten Referenzsignal verglichen. Bei hinreichender Übereinstimmung wertet die Steuereinheit 4 die detektierte Bewegung als Klappenstellbefehl und verstellt anschließend die Heckklappe 2. Zur Detektion der Bewegung sind der Näherungssensor bzw. die Steuereinheit 4 mit zwei Sensorelektroden 5 mittels jeweils einer Signalleitung 6 signalübertragungstechnisch gekoppelt. Ob der Fahrzeugnutzer zur Verstellung der Heckklappe 2 berechtigt ist, wird dabei daran beurteilt, ob ein (Berechtigungs-)Signal eines dem Fahrzeug 1 zugeordneten Funkschlüssels durch ein entsprechendes Bordsystem des Fahrzeugs 1 empfangen wird. Die beiden Sensorelektroden 5 sind als Teil eines Fahrzeugteils, konkret eines Unterfahrschutzes 7, an dem Fahrzeug 1 montiert. Der Unterfahrschutz 7 ist aus Metall(-blech) gefertigt. Um eine Beeinflussung, insbesondere eine Erdung der Sensorelektroden 5 durch den Unterfahrschutz 7 zu vermeiden, sind die beiden Sensorelektroden 5 in einen Sensorhalter 8 aus Elastomer elektrisch isoliert eingearbeitet (d. h. mit dem Elastomer umspritzt). Um des Weiteren eine Abschirmung des im Betrieb von den Sensorelektroden 5 ausgestrahlten elektrischen Messfelds durch den Unterfahrschutz 7 hin zur vermeiden, sind die Sensorelektroden 5 mit ihrem jeweiligen Sensorhalter 8 auf eine nach außen weisende Sichtfläche 9 des Unterfahrschutzes 7 aufgesetzt (s. Fig. 2). Somit kann sich das jeweilige Messfeld ungehindert zur Außenseite des Unterfahrschutzes 7 hin bzw. des Fahrzeugs 1 ausbreiten. In den Unterfahrschutz 7 sind außerdem Bohrungen 10 eingearbeitet, in denen die Sensorhalter 8 formschlüssig gehaltert sind und durch die hindurch die Signalleitungen 6 zur Rückseite 11 der Unterfahrschutzes 7 geführt sind. Die Sensorhalter 8 bilden ferner parallel zueinander und in Fahrzeugbreitenrichtung verlaufende "Gummiwülste", die dem Fahrzeugnutzer die Position der Sensorelektroden 5 anzeigen, so dass die Abgabe des Klappenstellbefehls erleichtert wird. Zudem tragen die Gummiwülste auch zu der sportlichen, massigen Optik des SUVs bei.

Die Sensorelektroden 5 sind optional unterschiedlich ausgerichtet. So ist insbesondere die untere der beiden Sensorelektroden 5 vorzugsweise nach unten gerichtet, so dass sie Annäherungen und Bedienereignisse in einem unterhalb des Unterfahrschutzes 7 angeordneten Detektionsraum erfasst. Die obere der beiden Sensorelektroden 5 ist dagegen vorzugsweise zumindest näherungsweise waagrecht ausgerichtet, so dass sie Annäherungen und Bedienereignisse etwa auf gleicher Höhe mit dieser Sensorelektrode 5 erfasst.

In einer weiteren Ausführung der Erfindung sind die Sensorelektroden 5 zusammen mit dem umgebenden Sensorhalter 8 in länglichen Schlitzen des Unterfahrschutzes 7 angeordnet. Der Sensorhalter 8 ist hierbei an der (von außen nicht sichtbaren) Rückseite des Unterfahrschutzes 7 verbreitert, so dass der Sensorhalter 8 durch Hinterschneidung des Unterfahrschutzes 7 gegen Ablösung gesichert sind. Die in den Unterfahrschutz 7 eingebrachten Schlitze können hierbei insbesondere an der Rückseite zur Aufnahme der Hinterschneidung stufenförmig oder kontinuierlich aufgeweitet sein.

Der Gegenstand der Erfindung ist nicht auf die vorstehend beschriebenen Ausführungsbeispiele beschränkt. Vielmehr können weitere Ausführungsformen der Erfindung von dem Fachmann aus der vorstehenden Beschreibung abgeleitet werden.

### Bezugszeichenliste

- 1: Kraftfahrzeug
- 2: Heckklappe
- 3: Klappenstellmotor
- 4: Steuereinheit
- 5: Sensorelektrode
- 6: Signalleitung
- 7: Unterfahrschutz
- 8: Sensorhalter
- 9: Sichtfläche
- 10: Bohrung
- 11: Rückseite

## Patentansprüche

1. Fahrzeugteil (7) für den Außenbereich eines Kraftfahrzeugs (1),
mit wenigstens einer Sensorelektrode (5) eines kapazitiven Näherungssensors, wobei die wenigstens eine Sensorelektrode (5) auf einer Sichtseite des Fahrzeugteils (7) angeordnet ist, wobei die wenigstens eine Sensorelektrode (5) in einem Sensorhalter (8) aufgenommen ist, wobei der Sensorhalter (8) auf der Sichtfläche (9) des Fahrzeugteils (7) aufliegt, und wobei das Fahrzeugteil (7) einen aus Metall gefertigten Unterfahrschutz bildet.

2. Fahrzeugteil (7) nach Anspruch 1,
mit zwei Sensorelektroden (5) desselben Näherungssensors, wobei die Sensorelektroden (5) jeweils langgestreckt mit einer gegenüber ihrer Breite vielfach größeren Länge ausgeführt und parallel zueinander ausgerichtet sind.

3. Fahrzeugteil (7) nach Anspruch 2,
wobei beide Sensorelektroden (5) in jeweils einem Sensorhalter (8) aufgenommen sind.

4. Fahrzeugteil (7) nach Anspruch 1 oder 3,
wobei der oder jeder Sensorhalter (8) aus weichem Kunststoff, insbesondere Elastomer gefertigt ist.

5. Fahrzeugteil (7) nach einem der Ansprüche 1 bis 4,
wobei es sich bei dem aus Metall gefertigten Unterfahrschutz um einen Heck-Unterfahrschutz handelt.

6. Kraftfahrzeug (1) mit einem Fahrzeugteil (7) nach einem der Ansprüche 1 bis 5.

## Claims

1. Vehicle part (7) for the exterior of a motor vehicle (1),
having at least one sensor electrode (5) of a capacitive proximity sensor, wherein the at least one sensor electrode (5) is arranged on a visible side of the vehicle part (7), wherein the at least one sensor electrode (5) is accommodated in a sensor holder (8), wherein the sensor holder (8) is supported on the visible surface (9) of the vehicle part (7), and wherein the vehicle part (7) forms an underride protection manufactured from metal.

2. Vehicle part (7) according to claim 1,
having two sensor electrodes (5) of the same proximity sensor, wherein the sensor electrodes (5) are each designed to be elongated with a length that is much greater than their width and are orientated parallel to each other,

3. Vehicle part (7) according to claim 2,
wherein the two sensor electrodes (5) are accommodated in a respective sensor holder (8),

4. Vehicle part (7) according to claim 1 or 3,
wherein the or each sensor holder (8) is manufactured from soft plastic, in particular elastomer.

5. Vehicle part (7) according to one of claims 1 to 4,
wherein the underride protection manufactured from metal is a rear underride protection.

6. Motor vehicle (1) having a vehicle part (7) according to one of claims 1 to 5,

## Revendications

1. Pièce de véhicule (7) pour l'extérieur d'un véhicule à moteur (1), comportant au moins une électrode de capteur (5) d'un capteur de proximité capacitif, la au moins une électrode de capteur (5) étant disposée sur un côté visible de la partie du véhicule (7), la au moins une électrode de capteur (5) étant reçue dans un support de capteur (8) sur le côté visible (9) de la pièce de véhicule (7), et la pièce de véhicule (7) formant une protection contre l'encastrement (7) en métal,

2. Pièce de véhicule (7) selon la revendication 1,
avec deux électrodes de capteur (5) du même capteur de proximité, les électrodes de capteur (5) étant chacune allongée avec une longueur plusieurs fois supérieure à leur largeur et alignées parallèlement l'une à l'autre.

3. Pièce de véhicule (7) selon la revendication 2,
dans laquelle les électrodes de capteur (5) sont reçues chacune dans un support de capteur (8).

4. Pièce de véhicule (7) selon la revendication 1 ou 3,
dans laquelle le ou chaque support de capteur (8) est réalisé en matière plastique souple, en particulier en élastomère.

5. Pièce de véhicule (7) selon l'une des revendications 1 à 4,
dans laquelle la protection contre l'encastrement en métal est une protection arrière contre l'encastrement.

6. Véhicule à moteur (1) avec une partie de véhicule (7) selon l'une des revendications 1 à 5.
